# EUROPEAN PATENT SPECIFICATION

(11) **EP 2 619 601 B1**
(45) Date of publication and mention of the grant of the patent: **12.11.2014**
(21) Application number: 10763314.1
(22) Date of filing: 20.09.2010
(51) Int. Cl.: G01R 31/333

(54) **DEVICE FOR TESTING OF HIGH SPEED DC BREAKERS**
VORRICHTUNG ZUM TESTEN VON HOCHGESCHWINDIGKEITS-DC-TRENNSCHALTERN
DISPOSITIF D'ESSAI DE DISJONCTEURS EN COURANT CONTINU À ACTION RAPIDE

(43) Date of publication of application: 31.07.2013
(73) Proprietor: Stevo Electric Bvba, 3971 Heppen (BE)
(72) Inventor: VOLKAERT, Stefaan Jean Louis, B-3971 Heppen (BE)
(74) Representative: Hostens, Veerle
(86) International application number: PCT/EP2010/005749
(87) International publication number: WO 2012/037948

(56) References cited:
- GB-A- 958 911
- JP-A- 6 118 146
- JP-A- 2003 115 242

## Description

This invention relates to a testing device for testing of high speed DC breakers.

Such high speed DC breakers can mainly be found in transportation, such as railways, subways, tramways, and this as well in traction substations as on rolling stock.

In order to test such high speed DC breakers, it is known to send an increasing current through the high speed DC breakers by means of a testing device and to measure at which current the switch automatically shuts off. Currents between 5000 A and 6000 A are rather common for testing such switches. Besides the current, also the time to shut off the switch and the transition resistance of the switch are measured.

Existing testing devices with which high speed DC breakers can be tested are very heavy and difficult to displace. Most such testing devices are therefore stationary testing devices. A high speed DC breakers which must be tested, must then be transported to a maintenance centre where the testing device is stationed in order to test this switch. After testing and maintenance, the high speed DC breaker must be transported back to the traction substation or the rolling stock where it is used and must be installed ready for use. This is however not only cumbersome, but also a risk full operation, as the high speed DC breakers can get out of order due to the transportation from the maintenance centre back to the traction substation or the rolling stock or during reinstallation.

As a high speed DC breaker is one of the most important protective appliances in the circuits in which it is used, the demand for testing devices, with which high speed DC breakers can be tested on-the-spot is high. *The Japanese patent* JP 2003 115242 A *discloses a breaker testing circuit using an AC current supply circuit to supply an AC current to a breaker, and switches to control the connection between the AC current source and the breaker.*

The only mobile testing device for testing of high speed DC breakers on-the-spot which is nowadays on the market has however some disadvantages.

This mobile testing device is composed of a control unit, different current units and a three-phase rectifier.

A first disadvantage is that the different modules of this mobile testing device have a weight which largely exceeds the limit of 25 kg in European directives for lifting and displacing of loads.

The control unit addresses the three-phase rectifier which applies a voltage between 0 and 400 V to the current units. The current units transform the voltage to a low voltage with a high current. The current increment of 500 A/s is determined by the motor speed which drives the three-phase autotransformer. Only more or less linearly increasing current profiles can thus be obtained.

The current profile which is created moreover comprises residual undulation, which is problematic for the measurement of the current and the speed of registration of this measurement. Due to the ripple it is very difficult or even impossible to reproduce the current profile. Certainly no comparison can be made between the test results with this mobile testing device and the test reports of the manufacturer of the high speed DC breaker. Where this testing device is manually operated, measurements are hardly reproducible. It is then often only possible to detect whether or not the switch does switch out at a certain point.

Also the working of the sliding contacts of the autotransformer is a critical point. At generating currents between 5000 A and 6500 A long cooling down periods are necessary. In master-slave embodiments, only maximum currents of 12000 A can thus be generated with such a device.

A further disadvantage of the existing mobile testing device is that a supply voltage of 380 V must be available on-the-site.

It is therefore an object of this invention to provide a testing device for testing of high speed DC breakers, which can be made much lighter than existing testing devices and with which current profiles can be created with minimal ripple and in a reproducible way.

This object is achieved by providing a testing device for testing of high speed DC breakers, comprising means for generating high currents for sending through the high speed DC breakers at testing, wherein the testing device comprises a DC voltage source, wherein the means for generating high currents comprise several cells for generating current pulses, which are interconnected in parallel into a power unit, wherein each cell comprises a first capacitor, connected in parallel with the DC voltage source, a first low pass filter, connected in parallel with the first capacitor, the first low pass filter comprising a second capacitor and an anti-retour diode and a second low pass filter, which are connectable in parallel with the second capacitor by means of a switch, the second low pass filter comprising a third capacitor, and the switch being provided for intermittently loading and unloading the third capacitor at intermittently opening and closing, in order to create the current pulses and wherein the means for generating high currents comprise synchronisation means for synchronising the intermittent opening and closing of the switches of the different cells, such that the current pulses of different cells are shifted in time with respect to each other.

With such testing device according to this invention an impressive reduction in weight can be achieved with respect to the known testing devices for testing of high speed DC breakers. It is possible to create a mobile device consisting of several modules, wherein each module weighs less than 25 kg (limit for lifting and displacing of loads according to European directives).

It is moreover possible to generate currents up to 15000A (or in a master-slave embodiment up to 30000A).

By using a third capacitor, the current from the DC voltage source is first loaded into the third capacitor, and further taken from the third capacitor if needed on the load side, by switching the switch of the cell. This creates an independency of the source versus the load.

By further synchronising current pulses of different cells in such a way that the current pulses of different cells are shifted in time with respect to each other, a current profile with a minimal ripple can be obtained.

Therefore, accurate measurements can be done in a highly reproducible way. By changing the frequency and the duration of the current pulses, almost any current profile can be generated. Linear current profiles can be parameterised. Non-linear current profiles can be created with which it is possible to simulate real situations of overload and/or defects.

The third capacitor of a testing device according to this invention is preferably a supercapacitor (also known as an electric double-layer capacitor), as herewith the weight of the testing device can be considerably reduced.

The testing device furthermore preferably comprises several said power units, which are interconnectable in parallel.

In this way, a great modularity can be achieved. By taking one single power unit or interconnecting two or more power units, maximum currents in a span of e.g. 300 A to 3000 A can be generated by the testing device.

The switches of each cell are preferably switches which can switch high power and which can be controlled using a low voltage. Therefore these switches comprise in a preferred embodiment one or more MOSFET's (abbreviation for Metal-Oxide Semiconductor Field-Effect Transistor).

In order to create a preferred mobile testing device, the DC voltage source preferably comprises one or more batteries.

With these batteries the testing device can be used independently from the presence of a power network.

In a specific embodiment of a testing device according to the invention, each cell comprises a control circuit, for controlling the switch of this cell.

Each cell furthermore preferably comprises a peak current guidance. In a testing device wherein each cell comprises a control circuit, this peak current guidance is preferably controlled by the control circuit.

Each cell moreover preferably comprises a measuring device for measuring the current level at the output of this cell. In a testing device wherein each cell comprises a control circuit, this measuring device is then preferably controlled by the control circuit.

A special testing device according to this invention comprises a control unit for controlling the total current level at the output of the testing device. In a testing device wherein each cell comprises a control circuit, this control circuit is then preferably controlled by the control unit.

The testing device furthermore preferably comprises a measuring device for measuring the total current level at the output of the testing device. In a testing device with a control unit, this measuring device is then preferably controlled by the control unit.

In a most preferred embodiment of a testing device according to this invention, the control unit is programmed in such a way that non-linear current profiles can be generated by the testing device.

This invention will now be commented on in greater depth based on the subsequent detailed description of preferred embodiments of testing devices according to this invention. The purpose of this description is exclusively to give illustrative examples and to indicate further advantages and special features of these testing devices, and may thus in no way be interpreted as a limitation of the scope of application of the invention or of the patent rights requested in the claims.

This detailed description will use reference numerals to refer to the appended drawings, in which:
- Figure 1 illustrates the circuit of a cell of a testing device according to this invention;
- Figure 2 illustrates the circuit of a power unit of a testing device according to this invention;
- Figure 3 illustrates the circuit of a testing device according to the invention;
- Figure 4 illustrates the cumulating of current pulses generated by several cells in a power unit.

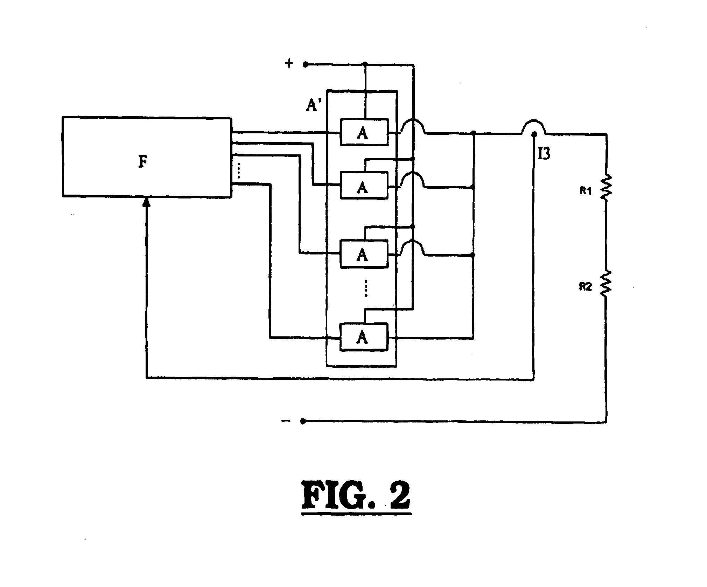

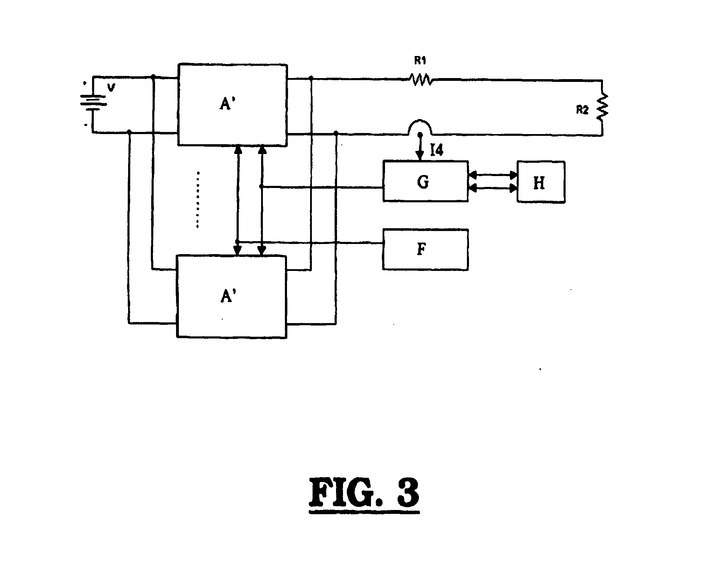

A specific embodiment of a testing device according to this invention comprises 5 power units (A') as illustrated in figure 2, which each can create a 3000 A current. When interconnected in parallel, as illustrated in figure 3, a 15000 A current can be generated with these power units (A').

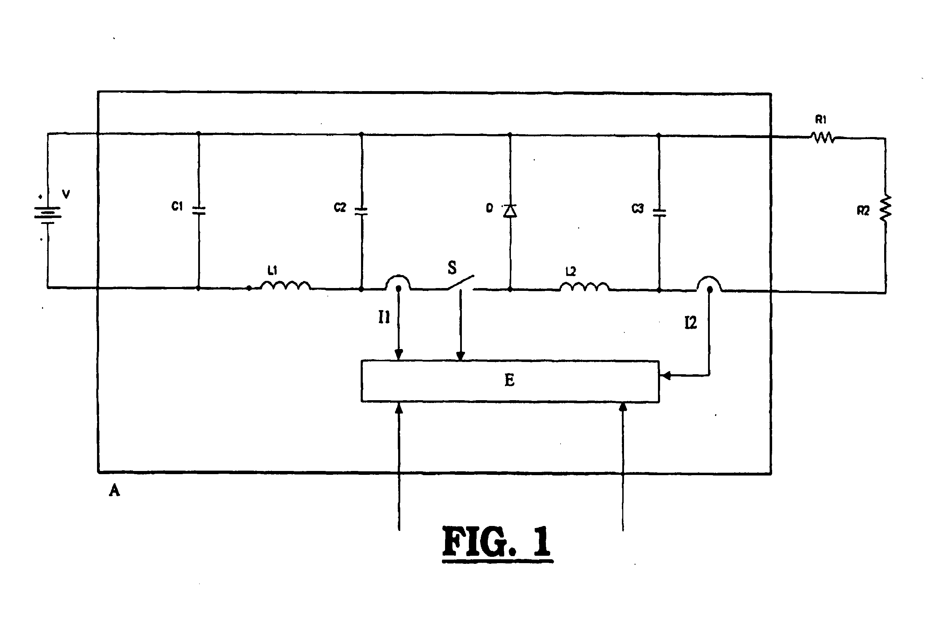

Each power unit (A') therefore comprises 60 power cells (A), as illustrated in figure 1, which are interconnected in parallel, as illustrated in figure 2. The cells (A) per power unit (A') are divided in 5 cells (A) on a board, and 12 boards in a power unit (A'). Such cell (A) can generate a nominal current of 50 A and a maximum current of 100 A. In the testing device, the components are not stressed, but used in the optimum range, wherein the nominal current of 50 A is normally taken as the maximum current which is generated with a cell (A). In this way, the best efficiency in temperature and life time can be achieved. Also in this way, when one of the components breaks down, such that one of the cells (A) gets out of order, the other cells (A) can compensate this break down.

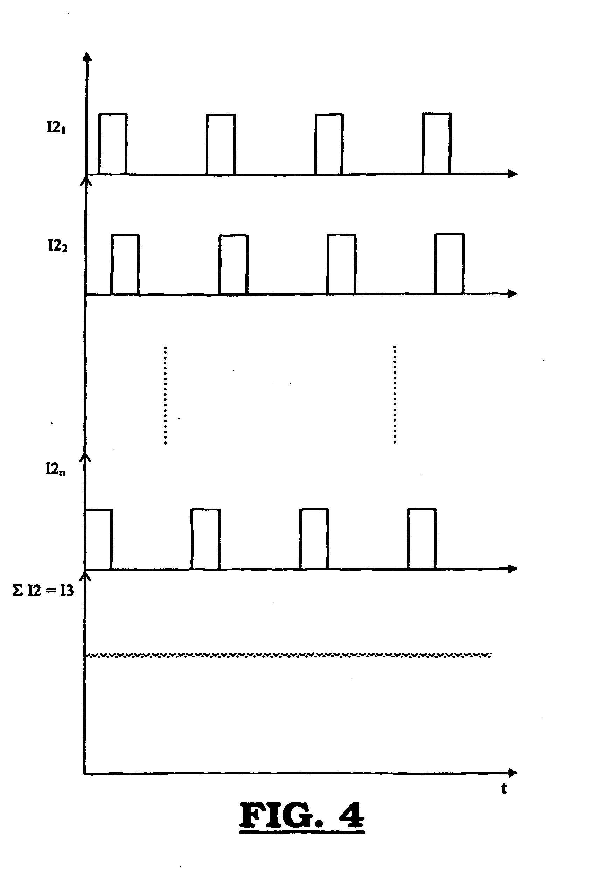

In each cell (A), as illustrated in figure 1, a switch circuit transfers the current from a third capacitor (C3) to a load (R1, R2) on the output side. The control circuit (E) of the cell (A) opens and closes the switch (S) in order to regulate the output level. The regulation takes into account the different voltage drops due to contact (R2) and cable (R1) resistances. In this way, current pulses (I2, I2₁₋ₙ) are created per cell (A), as illustrated in figure 4.

The current out from the DC voltage source (V) is first loaded into the third capacitor (C3), and further taken from (C3), if needed, on the load (R1, R2) side. This creates an independency of the source (V) versus the load (R1, R2).

The third capacitor (C3) is preferably a supercapacitor in order to keep the weight of the testing device low.

As DC voltage source e.g. 2 batteries of 55 Ah can be used. In this way, the testing device can be used independently from the presence of a power network.

Each cell (A) further comprises low pass filters (L1, C2, L2, C3) and an anti retour diode (D).

The switches (S) can e.g. comprise MOSFET's.

Each cell (A) further comprises a peak current guidance (I1) and a measuring device (I2) for measuring the current level at the output of the cell (A).

The testing device further comprises synchronisation means (F) for synchronising the intermittent opening and closing of the switches (S) of the different cells (A), such that the current pulses (I2, I2₁₋ₙ) of different cells (A) are shifted in time with respect to each other, as illustrated in figure 4. In this way, the total current (I3) of a power unit (A') has a minimal ripple and is highly reproducible. Also the total current (I4) of the testing device is then a current with minimal ripple which is highly reproducible.

The total current level (I4) is controlled by the control unit (G) that gives a threshold to the control circuit (E) per cell (A). This functioning regulates the current in order to reach the expected level at a particular time. This makes a quick response system able to manage appropriate di/dt.

By means of e.g. a touch screen (H) a user can chose the current profile to create and the way in which the current pulses (I2, I2₁₋ₙ) are to be synchronised.

The total current (I4) thus created can be influenced by e.g. using one or more power units (A') to create this total current (I4) and/or by e.g. varying the duration and the frequency of the different current pulses (I2, I2₁₋ₙ) of the different cells (A), etc.

There are multiple solutions for providing the control and synchronisation means (E, F, G) of the testing device. Separate control circuits can be taken, or microprocessors, or even a computer system, in order to control and synchronise the current pulses (I2, I2₁₋ₙ).

There are also multiple solutions for providing a user interface (H). A touch screen is only one of the possible solutions.

The testing device can be realised e.g. comprising a separate control device, several separate current devices (e.g. the different power units (A')) and a battery device. Each of these modules can then be designed such that it weighs less than 25 kg (limit for lifting and displacing of loads according to European directives).

## Claims

1. Testing device for testing of high speed DC breakers , comprising means for generating high currents for sending through the high speed DC breakers at testing, **characterised in that** the testing device comprises a DC voltage source (V), **in that** the means for generating high currents comprise several cells (A) for generating current pulses, which are interconnected in parallel into a power unit (A'), wherein each cell (A) comprises a first capacitor (C1), connected in parallel with the DC voltage source (V), a first low pass filter (L1, C2), connected in parallel with the first capacitor (C1), the first low pass filter (L1, C2) comprising a second capacitor (C2) and an anti-retour diode (D) and a second low pass filter (L2, C3), which are connectable in parallel with the second capacitor (C2) by means of a switch (S), the second low pass filter (L2, C3) comprising a third capacitor (C3), and the switch (S) being provided for intermittently loading and unloading the third capacitor (C3) at intermittently opening and closing, in order to create the current pulses and **in that** the means for generating high currents comprise synchronisation means (F) for synchronising the intermittent opening and closing of the switches (S) of the different cells (A), such that the current pulses of different cells (A) are shifted in time with respect to each other.

2. Testing device according to claim 1, **characterised in that** said third capacitor (C3) is a supercapacitor.

3. Testing device according to any of the preceding claims **characterised in that** the testing device comprises several said power units (A'), which are interconnectable in parallel.

4. Testing device according to any of the preceding claims **characterised in that** the switches (S) of each cell (A) comprise one or more MOSFET's.

5. Testing device according to any of the preceding claims **characterised in that** the DC voltage source (V) comprises one or more batteries.

6. Testing device according to any of the preceding claims **characterised in that** each cell (A) comprises a control circuit (E), for controlling the switch (S) of this cell (A).

7. Testing device according to any of the preceding claims **characterised in that** each cell (A) comprises a peak current guidance (I1).

8. Testing device according to claim 6 and 7, **characterised in that** the peak current guidance (I1) is controlled by the control circuit (E).

9. Testing device according to any of the preceding claims **characterised in that** each cell (A) comprises a measuring device (I2) for measuring the current level at the output of this cell.

10. Testing device according to claim 6 and 9, **characterised in that** the measuring device (I2) is controlled by the control circuit (E).

11. Testing device according to any of the preceding claims **characterised in that** the testing device comprises a control unit (G) for controlling the total current level at the output of the testing device.

12. Testing device according to claim 6 and 11, **characterised in that** each control circuit (E) is controlled by the control unit (G).

13. Testing device according to any of the preceding claims **characterised in that** the testing device comprises a measuring device (I4) for measuring the total current level at the output of the testing device.

14. Testing device according to claim I1 and 13, **characterised in that** the measuring device is controlled by the control unit (G).

15. Testing device according to any of the claims 11, 12 or 14 **characterised in that** the control unit (G) is programmed in such a way that non-linear current profiles can be generated by the testing device.

## Patentansprüche

1. Prüfvorrichtung zum Prüfen von Hochgeschwindigkeits-DC-Trennschaltern, umfassend Mittel zum Erzeugen von hohen Strömen zum Senden durch die Hochgeschwindigkeits-DC-Trennschalter beim Prüfen, **dadurch gekennzeichnet, dass** die Prüfvorrichtung eine DC-Spannungsquelle (V) umfasst, dass die Mittel zum Erzeugen von hohen Strömen mehrere Zellen (A) zum Erzeugen von Stromimpulsen umfassen, die parallel miteinander zu einer Leistungseinheit (A') verbunden sind, wobei jede Zelle (A) einen ersten Kondensator (C1), der parallel mit der DC-Spannungsquelle (V) verbunden ist, einen ersten Tiefpassfilter (L1, C2), der parallel mit dem ersten Kondensator (C1) verbunden ist, wobei der erste Tiefpassfilter (L1, C2) einen zweiten Kondensator (C2) und eine Rückleitungsschutzdiode (D) umfasst, und einen zweiten Tiefpassfilter (L2, C3) umfasst, die mittels eines Schalters (S) parallel mit dem zweiten Kondensator (C2) verbindbar sind, wobei der zweite Tiefpassfilter (L2, C3) einen dritten Kondensator (C3) umfasst und der Schalter (S) zum intermittierenden Laden und Entladen des dritten Kondensators (C3) bei intermittierendem Öffnen und Schließen bereitgestellt ist, um die Stromimpulse zu erzeugen, und dadurch, dass die Mittel zum Erzeugen von hohen Strömen Synchronisationsmittel (F) zum Synchronisieren des intermittierenden Öffnens und Schließens der Schalter (S) der verschiedenen Zellen (A) umfassen, sodass die Stromimpulse der verschiedenen Zellen (A) zueinander zeitverschoben sind.

2. Prüfvorrichtung nach Anspruch 1, **dadurch gekennzeichnet, dass** der dritte Kondensator (C3) ein Superkondensator ist.

3. Prüfvorrichtung nach einem der vorhergehenden Ansprüche, **dadurch gekennzeichnet, dass** die Prüfvorrichtung mehrere Leistungsaggregate (A') umfasst, die parallel miteinander verbindbar sind.

4. Prüfvorrichtung nach einem der vorhergehenden Ansprüche, **dadurch gekennzeichnet, dass** die Schalter (S) jeder Zelle (A) einen oder mehrere MOSFETs umfassen.

5. Prüfvorrichtung nach einem der vorhergehenden Ansprüche, **dadurch gekennzeichnet, dass** die DC-Spannungsquelle (V) eine oder mehrere Batterien umfasst.

6. Prüfvorrichtung nach einem der vorhergehenden Ansprüche, **dadurch gekennzeichnet, dass** die Zelle (A) eine Steuerschaltung (E) zum Steuern des Schalters (S) dieser Zelle (A) umfasst.

7. Prüfvorrichtung nach einem der vorhergehenden Ansprüche, **dadurch gekennzeichnet, dass** jede Zelle (A) eine Spitzenstromführung (I1) umfasst.

8. Prüfvorrichtung nach Anspruch 6 und 7, **dadurch gekennzeichnet, dass** die Spitzenstromführung (I1) von der Steuerschaltung (E) gesteuert wird.

9. Prüfvorrichtung nach einem der vorhergehenden Ansprüche, **dadurch gekennzeichnet, dass** jede Zelle (A) eine Messvorrichtung (12) zum Messen des Strompegels am Ausgang dieser Zelle umfasst.

10. Prüfvorrichtung nach Anspruch 6 und 9, **dadurch gekennzeichnet, dass** die Messvorrichtung (I2) von der Steuerschaltung (E) gesteuert wird.

11. Prüfvorrichtung nach einem der vorhergehenden Ansprüche, **dadurch gekennzeichnet, dass** die Prüfvorrichtung eine Steuereinheit (G) zum Steuern des Gesamtstrompegels am Ausgang der Prüfvorrichtung umfasst.

12. Prüfvorrichtung nach Anspruch 6 und 11, **dadurch gekennzeichnet, dass** jede Steuerschaltung (E) von der Steuereinheit (G) gesteuert wird.

13. Prüfvorrichtung nach einem der vorhergehenden Ansprüche, **dadurch gekennzeichnet, dass** die Prüfvorrichtung eine Messvorrichtung (14) zum Messen des Gesamtstrompegels am Ausgang der Prüfvorrichtung umfasst.

14. Prüfvorrichtung nach Anspruch 11 und 13, **dadurch gekennzeichnet, dass** die Messvorrichtung von der Steuereinheit (G) gesteuert wird.

15. Prüfvorrichtung nach einem der Ansprüche 11, 12 oder 14, **dadurch gekennzeichnet, dass** die Steuereinheit (G) derart programmiert ist, dass nicht lineare Stromprofile von der Prüfvorrichtung erzeugt werden können.

## Revendications

1. Dispositif de test pour tester des disjoncteurs CC haute vitesse, comprenant des moyens pour générer de forts courants à envoyer à travers les disjoncteurs CC haute vitesse à tester, **caractérisé en ce que** le dispositif de test comprend une source de tension CC (V), **en ce que** les moyens pour générer de forts courants comprennent plusieurs cellules (A) pour générer des impulsions de courant, qui sont interconnectées en parallèle dans une unité de puissance (A'), où chaque cellule (A) comprend un premier condensateur (C1), connecté en parallèle avec la source de tension CC (V), un premier filtre passe-bas (L1, C2), connecté en parallèle avec le premier condensateur (C1), le premier filtre passe-bas (L1, C2) comprenant un second condensateur (C2) et une diode anti-retour (D) et un second filtre passe-bas (L2, C3), qui sont connectables en parallèle avec le second condensateur (C2) au moyen d'un commutateur (S), le second filtre passe-bas comprenant un troisième condensateur (C3), et le commutateur (S) étant prévu pour charger et décharger par intermittence le troisième condensateur (C3) à une ouverture et fermeture par intermittence, de façon à créer les impulsions de courant et **en ce que** les moyens pour générer de forts courants comprennent des moyens de synchronisation (F) pour synchroniser l'ouverture et la fermeture par intermittence des commutateurs (S) des différentes cellules (A), de façon à ce que les impulsions de courant de différentes cellules (A) soient décalées dans le temps les unes par rapport aux autres.

2. Dispositif de test selon la revendication 1, **caractérisé en ce que** ledit troisième condensateur (C3) est un supercondensateur.

3. Dispositif de test selon l'une quelconque des revendications précédentes **caractérisé en ce que** le dispositif de test comprend plusieurs desdites unités de puissance (A'), qui sont interconnectables en parallèle.

4. Dispositif de test selon l'une quelconque des revendications précédentes **caractérisé en ce que** les commutateurs (S) de chaque cellule (A) comprennent un ou plusieurs MOSFETs.

5. Dispositif de test selon l'une quelconque des revendications précédentes **caractérisé en ce que** la source de tension CC (V) comprend une ou plusieurs batteries.

6. Dispositif de test selon l'une quelconque des revendications précédentes **caractérisé en ce que** chaque cellule (A) comprend un circuit de commande (E), pour commander le commutateur (S) de cette cellule (A).

7. Le dispositif de test selon l'une quelconque des revendications précédentes **caractérisé en ce que** chaque cellule (A) comprend un guidage de courant de crête (I1).

8. Le dispositif de test selon les revendications 6 et 7, **caractérisé en ce que** le guidage de courant de crête (I1) est commandé par le circuit de commande (E).

9. Dispositif de test selon l'une quelconque des revendications précédentes **caractérisé en ce que** chaque cellule (A) comprend un dispositif de mesure (12) pour mesurer le niveau de courant à la sortie de cette cellule.

10. Dispositif de test selon les revendications 6 et 9, **caractérisé en ce que** le dispositif de mesure (12) est commandé par le circuit de commande (E).

11. Le dispositif de test selon l'une quelconque des revendications précédentes **caractérisé en ce que** le dispositif de test comprend une unité de commande (G) pour commander le niveau de courant total à la sortie du dispositif de test.

12. Dispositif de test selon les revendications 6 et 11, **caractérisé en ce que** chaque circuit de commande (E) est commandé par l'unité de commande (G).

13. Dispositif de test selon l'une quelconque des revendications précédentes **caractérisé en ce que** le dispositif de test comprend un dispositif de mesure (14) pour mesurer le niveau de courant total à la sortie du dispositif de test.

14. Dispositif de test selon les revendications 11 et 13, **caractérisé en ce que** le dispositif de mesure est commandé par l'unité de commande (G).

15. Dispositif de test selon l'une quelconque des revendications 11, 12 ou 14, **caractérisé en ce que** l'unité de commande (G) est programmée de façon à ce des profiles de courant non-linéaire puissent être générés par le dispositif de test.
